# NEUE EUROPÄISCHE PATENTSCHRIFT

(11) **EP 2 171 482 B2**
(45) Veröffentlichungstag und Bekanntmachung des Hinweises auf die Entscheidung über den Einspruch: **03.06.2015**
(45) Hinweis auf die Patenterteilung: 12.01.2011
(21) Anmeldenummer: 08773804.3
(22) Anmeldetag: 02.07.2008
(51) Int. Cl.: G01R 1/04, G01R 31/12, H05K 5/02, H05K 5/03, G01R 31/14

(54) **MOBILES HOCHSPANNUNGSPRÜFGERÄT MIT GEHÄUSE**
MOBILE HIGH-VOLTAGE TEST SET WITH HOUSING
APPAREIL DE TEST HAUTE TENSION MOBILE MUNI D'UN BOÎTIER

(30) Priorität: 25.07.2007 DE 102007034558
(43) Veröffentlichungstag der Anmeldung: 07.04.2010
(73) Patentinhaber: B2 Electronic GmbH, 6833 Klaus (AT)
(72) Erfinder: BLANK, Rudolf, A-6832 Sulz (AT); BALDAUF, Stefan, A-6830 Rankweil (AT)
(74) Vertreter: Grättinger Möhring von Poschinger Patentanwälte Partnerschaft
(86) Internationale Anmeldenummer: PCT/EP2008/005383
(87) Internationale Veröffentlichungsnummer: WO 2009/012870

(56) Entgegenhaltungen:
- CH-A- 633 930
- US-A- 4 998 067
- US-A- 5 631 570
- US-A- 5 803 603
- US-A1- 2006 198 104
- RAYTECH GMBH: 'Preisliste 2005,', 2005
- MEGGER, DALLAS: 'Firmenzeitschrift The Electrical Tester, Gerät Biddle BGFT, Betriebsanleitung, Vergrösserte Gerätedarstellung Megger BGFT, Chassis und Abdeckplattenaufbau', Juni 2003

## Beschreibung

Die vorliegende Erfindung betrifft ein mobiles Hochspannungsprüfgerät umfassend eine Elektronik mit Mitteln zur Bereitstellung einer im kV-Bereich liegenden Prüfspannung, einen mit der Elektronik zusammenwirkenden Bedienbereich, wenigstens einen Anschluss für das zu prüfende Bauteil bzw. Kabel und ggfs. für eine externe Spannungsversorgung, ein Gehäuse zur dauerhaften Aufnahme der Elektronik, sowie ein innerhalb des Gehäuses angeordnetes Kühlsystem zur Kühlung der Elektronik, welches eine Luftkühlung mit einer Luftzu- und einer Luftabführung umfasst.

Derartige Hochspannungsprüfgeräte werden insbesondere zur so genannten VLF(Very Low Frequency)-Prüfung von Kabeln eingesetzt, bei welcher ein auf Beschädigungen zu prüfendes Kabel mit einer - je nach Art und Länge des zu prüfenden Kabels gewählten - Wechselspannung in einem Bereich von wenigen kV bis hin zu mehreren 10 kV oder gar 100 kV bei einer niedrigen Frequenz von bevorzugt 0,1 Hz beaufschlagt wird. Dabei ist es möglich, Kabel mit mehreren Kilometern Länge auf Schäden an ihrer Isolation oder dgl. zu testen. Gattungsgemäße Hochspannungsprüfgeräte eignen sich jedoch auch zur Prüfung von anderen elektrischen Bauteilen oder Baugruppen, wie beispielsweise Kondensatoren, Widerständen, Transformatoren, Motoren, Generatoren, Schaltern oder Relais. Ebenso kann ein gattungsgemäßes Hochspannungsprüfgerät jedoch auch für eine Gleichspannungsprüfung oder eine so genannte 50 Hz-Prüfung ausgebildet sein.

Die für den Prüfbetrieb notwendige Prüfspannung wird von der Elektronik eines gattungsgemäßen Prüfgeräts bereitgestellt, indem bevorzugt eine an einem Anschluss für eine externe Spannungsverspannung anliegende Eingangsspannung mittels eines im so genannten AB-Betrieb arbeitenden Verstärkers verstärkt bzw. transformiert wird. Der Begriff Elektronik ist vorliegend weit zu verstehen, da auch mittels einfacher Schaltungsanordnungen (z.B. aus wenigstens einem Schalter und einem Widerstand) eine für die vorgesehene Anwendung geeignete Prüfspannung bereitgestellt werden kann. Als externe Spannungsversorgung kann, insbesondere bei Messungen im Feld, auch ein mobiler Spannungsgenerator zum Einsatz kommen. Denkbar ist jedoch auch ein Batteriebetrieb eines gattungsgemäßen Hochspannungsprüfgeräts, so daß ein etwa vorhandener Anschluss für eine externe Spannungsversorgung der Wiederaufladung der Batterie dienen kann.

Gattungsgemäße Hochspannungsprüfgeräte weisen außerdem einen Bedienbereich auf, der vorzugsweise neben einigen Bedienelementen zur Wahl der Prüfspannung bzw. des zeitlichen Verlaufs der Prüfspannung im Sinne eines Prüfprogramms auch ein Display und/oder sonstige Anzeigelemente aufweist, mit denen die Funktionen des Geräts und das Ergebnis der Prüfung überwacht werden können.

Die Elektronik von gattungsgemäßen Hochspannungsprüfgeräten hat jedoch eine - im Vergleich zu sonstigen mobilen technischen Geräten - außerordentlich hohe Wärmeentwicklung, da bei der Hochspannungsverstärkung bzw. -schaltung je nach konkreter Ausgestaltung der Elektronik hohe Wärmeverluste in einer Größenordnung ab 20 W bis hin zu einigen kW auftreten, die als Abwärme abzuführen sind. An das Kühlsystem sind daher besonders hohe Anforderungen zu stellen, was sich insbesondere vor dem Hintergrund, dass aus Gründen einer möglichst hohen Mobilität immer kompaktere und leichtere Geräte erwünscht sind, als besonders schwierig erweist.

Die vorliegende Erfindung betrifft dabei solche Hochspannungsgeräte, bei welchen das Kühlsystem eine Luftkühlung mit einer Luftzuführung und einer Luftabführung aufweist, wobei die Luftkühlung entweder bereits das Primärkühlsystem des Hochspannungsprüfgeräts oder ein Sekundärsystem z.B. für eine Flüssigkeits-, insbesondere Ölkühlung, darstellt. Das Kühlsystem ist vorliegend in das Gehäuse des Hochspannungsprüfgeräts integriert, in welchem auch die Elektronik des Prüfgeräts dauerhaft aufgenommen ist, wobei im Stand der Technik üblicherweise in einer oder mehreren Seitenwänden des Gehäuses Durchbrechungen als Luftzu- und/oder Luftabführung vorgesehen sind.

Bei primär luftgekühlten Hochspannungsprüfgeräten ist zu berücksichtigen, dass in diesem Fall auch besonders hohe Anforderungen an den Kühlkörper bzw. an dessen Anbindung an die Elektronik gestellt werden müssen. Diesbezüglich sei auf die PCT/AT 2006/000510 verwiesen, wo eine geeignete Kühlkörperanordnung für ein gattungsgemäßes Hochspannungsprüfgerät beschrieben ist.

Die vorstehend beschriebenen Hochspannungsprüfgeräte werden in mobilem Einsatz zu dem jeweils zu prüfenden Kabel oder Bauteil transportiert und dann vor Ort in Betrieb genommen. Dabei ist besonderer Wert darauf zu legen, dass die Elektronik eines gattungsgemäßen Hochspannungsprüfgeräts, insbesondere auch während seines Transportes, ausreichend gegen eindringenden Schmutz bzw. Staub und/oder gegen eindringendes Wasser geschützt ist.

Bisher ist hierzu meist ein separates Transportgehäuse, z.B. in Form eines Transportkoffers oder einer Transporttasche, vorgesehen, aus welchem das Hochspannungsprüfgerät vor seiner Inbetriebnahme herausgenommen werden muss. Dies ist bei den gattungsgemäßen Geräten in Anbetracht eines Gewichts von häufig mehreren 10 kg zwar umständlich, jedoch notwendig, um zum einen freien Zugang zu den Anschlüssen des Hochspannungsprüfgeräts zu haben und um zum anderen die Luftzu- und Luftabführung freizugeben, da anderenfalls das Gerät schnell überhitzt.

Für verschiedene technische Geräte sind jedoch z.B. aus der US 5,631,570, der US 5,803,603, der US 4,998067 bereits Gerätegehäuse bekannt, die dauerhaft die Elektronik aufnehmen und einen gewissen Schutz gegen möglicherweise eindringendes Wasser oder Staub bieten. Diese sind jedoch allesamt nicht hinreichend für den Transport und/oder einen Betrieb des jeweiligen Geräts bei widrigen Umgebungsbedingungen, wie z.B. Regen, geeignet.

CH 633930 und der "Impulse Generator" gemäß Instruction Manual AVTM6514J der Firma Megger offenbaren ein Gehäuse für elektrische Geräte bzw. ein Hochspannungsprüfgerät mit Luftkühlung und mit einer schwenkbaren Abdeckklappe.

Vor diesem Hintergrund ist es die Aufgabe der vorliegenden Erfindung, ein gattungsgemäßes Hochspannungsprüfgerät mit einfachen Mitteln gut gegen eindringenden Schmutz und/oder eindringendes Wasser zu schützen. Ferner soll ein reibungsloser und möglichst einfacher Betrieb des Hochspannungsprüfgeräts bei ausreichender Leistung des Kühlsystems gewährleistet sein.

Diese Aufgabe wird von einem mobilen Hochspannungsgerät nach Anspruch 1 gelöst.

Dabei ist vorgesehen, dass das - die Elektronik des Hochspannungsgeräts dauerhaft aufnehmende - Gehäuse einen zwischen einer Öffnungs- und einer Schließstellung bewegbaren Deckelteil aufweist, durch welchen in seiner Schließstellung sämtliche Anschlüsse, der Bedienbereich sowie die Luftzu- und Luftabführung verdeckt sind, während in seiner Öffnungsstellung sämtliche Anschlüsse, der Bedienbereich sowie die Luftzu- und Luftabführung freigegeben sind.

Mithin wird erfindungsgemäß ein Hochspannungsprüfungsgerät bereitgestellt, welches zum besseren Schutz gegen eindringendes Wasser und Schmutz ein vollständig mittels eines Deckelteil verschließbares Gehäuse aufweist, bei welchem in Schließstellung des Deckels keinerlei Wasser und/oder Staub oder sonstiger Schmutz in die Anschlüsse, die Luftzu- und Luftabführung und die Bedienelemente des Bedienbereichs eindringen kann. Dabei ist ferner vorgesehen, dass Luftzuführung, Luftabführung, sämtliche Anschlüsse und auch der Bedienbereich so angeordnet sind, dass sie bei geöffnetem Deckelteil derart frei zugänglich bzw. freigegeben sind, dass das Gerät ohne Gefahr einer Überhitzung ohne weiteres in Betrieb genommen werden kann. Von wesentlicher Bedeutung für die vorliegende Erfindung ist zudem, dass eine separate Luftzuführung und eine separate Luftabführung vorgesehen sind, so dass - bei geöffnetem Deckelteil - ein definierter Luftstrom durch das Gehäuse erzielbar ist, mit welchem eine hohe Abwärme effektiv abgeführt werden kann.

Soweit Anspruch 1 davon spricht, dass die Anschlüsse und der Bedienbereich bei geöffnetem Deckelteil freigegeben sind, so ist dies also dahingehend zu verstehen, dass im Falle der Anschlüsse hinreichend Platz zum Anschluss der daran anzuschließenden Kabel bzw. Bauteile vorhanden ist und dass im Falle des Bedienbereichs sämtliche Bedienelemente und ggfs. vorhandenen Anzeigeelemente ohne Einschränkung bedienbar bzw. ablesbar sind. Luftzu- und Luftabführung sind dergestalt freizugeben, dass ein zur Kühlung des Geräts ausreichender Luftstrom im Bereich der Luftzuführung angesaugt und im Bereich der Luftabführung wieder als Abluft abgegeben werden kann.

In einer ersten bevorzugten Weiterbildung der Erfindung ist vorgesehen, dass das Deckelteil in Form eines an der Oberseite des übrigen Gehäuses schwenkbar befestigten Gehäusedeckels ausgebildet ist, welcher in Schließstellung das Gehäuse vollständig verschließt. Damit ist das gesamte Hochspannungsprüfgerät in Schließstellung des Deckelteils von seinem Gehäuse vollständig und vollumfänglich verschlossen, wobei durch einfaches Verschwenken des Deckelteils sämtliche zum Betrieb des Geräts erforderlichen Gerätebauteile und Anschlüsse inklusive der Luftzu- und Luftabführung freigegeben sind. Dies entspricht einem Schutzgrad, der es erlaubt, das Gerät auch bei widrigsten Bedingungen zu transportieren.

Ferner ist bei einem erfindungsgemäßen Hochspannungsprüfgerät der vorgenannten Art in vorteilhafter Weise vorgesehen, dass Luftzuführung und Luftabführung des in das Gehäuse integrierten Kühlsystems auf einander gegenüberliegenden Seiten in einer die Oberseite des in Schließstellung vom Gehäusedeckel abgedeckten Teils des Hochspannungsprüfgeräts bildenden Deckplatte ausgebildet sind. Dadurch kann die Zuluft für die Luftkühlung - bei Betrieb des Geräts mit geöffnetem Deckelteil - im Bereich der Oberseite des Geräts auf einer Seite der Deckplatte angesaugt und die erwärmte Abluft auf der anderen Seite der Deckplatte wieder abgegeben werden. Zur Luftansaugung wird in bevorzugter Weise ein handelsüblicher Lüfter verwendet, der an geeigneter Stelle in das Gehäuse integriert ist. Luftzuführung und Luftabführung sind durch ihre Anordnung auf einander gegenüberliegenden Seiten an der Oberseite des Hochspannungsprüfgeräts hinreichend weit voneinander beabstandet, um den hohen Anforderungen an die erforderliche Kühlleistung gerecht zu werden, da die beim Durchgang durch das Hochspannungsprüfgerät erwärmte Abluft nicht nochmals im Bereich der Luftzuführung angesaugt wird. Zudem ist infolge der gehäuseoberseitig vorgesehenen Anordnung von Luftzu- und Luftabführung gewährleistet, dass ggfs. von der Seite des Hochspannungsprüfgeräts kommendes Spritzwasser nicht ohne weiteres in das Gerätegehäuse eindringen kann. Die Kühlluft kann bei der genannten Anordnung von Luftzu- und Luftabführung in voneinander entfernten seitlichen Randbereichen der Deckplatte überdies - wie weiter unten ausgeführt - in Längsrichtung durch das gesamte Gehäuse geleitet werden.

Von Vorteil ist es dabei ferner, wenn an der Luftzuführung und Luftabführung jeweils Umlenkmittel für die Zuluft und die Abluft vorgesehen sind, die beim Betrieb des Hochspannungsprüfgeräts ein seitliches Ansaugen der Zuluft und eine seitliche Abgabe der Abluft zur gegenüberliegenden Seite bewirken. Dies erhöht abermals die Effektivität des Kühlsystems eines erfindungsgemäßen Hochspannungsprüfgeräts, da infolge der auf einer Seite des Geräts erfolgenden seitlichen Ansaugung der Zuluft und der auf der anderen Seite in gleiche Richtung, d.h. zur gegenüberliegenden Seite hin, erfolgenden Abgabe der Abluft keine Wärmeglocke um das Hochspannungsprüfgerät herum entsteht.

Ferner ist das Hochspannungsprüfgerät bevorzugt so ausgestaltet, dass Luftzuführung und Luftabführung nur zur Seite hin offen und nach oben hin dauerhaft abgedeckt sind. Dies kann in besonders einfacher Weise durch die vorgenannten, hutzenartigen Umlenkmittel realisiert sein. Ein erfindungsgemäßes Hochspannungsprüfgeräts kann dadurch auch bei Regen ohne weitere Schutzmittel betrieben werden, da infolge der oberen Abdeckung von Luftzu- und Luftabführung kein im Wesentlichen vertikal von oben kommender Regen in die Luftzu- und Luftabführung eindringen kann. Das Gerät eignet sich somit - selbst bei geöffnetem Deckel - zum Feldeinsatz bei Regen, jedenfalls wenn auch der Bedienbereich und die Bedienelemente gegen eindringendes Spritzwasser abgedichtet sind. Zu diesem Zweck ist bevorzugt auch dafür Sorge zu tragen, dass auch die Anschlüsse - insbesondere bei eingesteckten Anschlusskabeln - möglichst gut gegen Spritzwasser geschützt bzw. abgedichtet sind, wozu beispielsweise auch in deren Bereich entsprechende Abdeckmittel vorgesehen sein können. Das vorliegend beschriebene Hochspannungsprüfgerät kann damit auf besonders einfache Weise den hohen Schutzanforderungen der Schutzart IP 54 nach DIN EN 60529 bzw. VDE 0470 gerecht werden.

In äußerst vorteilhafter Weise ist dabei vorgesehen, dass die Kühl- bzw. Abluft im Bereich der Luftzu- bzw. Luftabführung im Wesentlichen horizontal oder von bzw. nach schräg unten angesaugt bzw. abgegeben werden. Entsprechende Umlenkmittel, die bei gleichzeitiger Abdeckung von Luftzu- bzw. Luftabführung den von der Seite aus horizontaler oder schräger Richtung angesaugten Luftstrom entsprechend ins Gehäuseinnere leiten bzw. die Abluft auf der gegenüberliegenden Seite wieder entsprechend abgeben sind einfach zu konstruieren. Im Bereich der jeweiligen Umlenkmittel sind bevorzugt eine Mehrzahl an Luftschlitzen ausgebildet, um auch ein (seitliches) Eindringen von Schmutz oder Wasser mit dem Luftstrom möglichst weitgehend zu unterbinden. Bei dem Gehäuse eines erfindungsgemäßen Hochspannungsprüfgeräts kann es sich in bevorzugter Weise um ein keinerlei Durchbrechungen nach außen aufweisendes Kunststoffgehäuse mit einem schwenkbar daran festigten Deckelteil aus dem gleichen Kunststoff handeln. Da erfindungsgemäß eine Luftzu- und eine Luftabführung so angeordnet sind, dass sie bei geöffnetem Deckelteil freigegeben sind, ist - trotz vollständig verschließbarem Kunststoffgehäuse - nicht mit einem Hitzestau innerhalb des Gehäuses zu rechnen.

Wie bereits weiter oben erwähnt, kann durch die vorstehenden Maßnahmen in bevorzugter Weise und trotz der hohen abzutransportierenden Verlustwärme ein kompaktes Hochspannungsprüfgerät realisiert werden, bei welchem die Luftkühlung das primäre Kühlsystem darstellt. Hierzu ist zweckmäßiger Weise ein Kühlsystem zu realisieren, welches einen ersten Luftführungsabschnitt aufweist, in dem ein Lüfter zur Ansaugung der Kühlluft angeordnet ist und in welchem die durch die Luftzuführung im Bereich der Gehäuseoberseite angesaugte Kühlluft an der Innenseite einer Gehäuseseitenwand zum Gehäuseboden geleitet wird, wobei sich dem ersten Luftführungsabschnitt ein zweiter Luftführungsabschnitt anschließt, der das Gehäuse gehäusebodenseitig in Längsrichtung durchquert, einem Kühlkörper der Elektronik angrenzt und zu einem dritten Luftführungsabschnitt an der gegenüberliegenden Gehäuseseitenwand führt, in welchem die Kühlluft wieder in Richtung zur Gehäuseoberseite zur Luftabführung geführt wird. Anstelle einer gehäusebodenseitigen Durchströmung des Gehäuses in Längsrichtung kann jedoch auch eine Luftführung realisiert sein, bei welcher der zweite Luftführungsabschnitt das Gehäuse - bezogen auf seine Höhe - gehäusemittig in Längsrichtung durchquert.

Das wie vorstehend ausgeführte Kühlsystem zeichnet sich durch eine besonders effektive Abführung der von der Elektronik erzeugten Abwärme aus, indem die gehäusebodenseitig das Gehäuse in Längsrichtung durchquerende Kühlluft in diesem Bereich den mit der Elektronik wärmeleitend verbundenen Kühlkörper umströmt, um anschließend das Gehäuse wieder auf seiner Oberseite - bevorzugt durch die bereits genannten Umlenkmittel zur Seite hin abgelenkt - durch die Luftabführung zu verlassen. Der Kühlkörper dehnt sich dabei in vorteilhafter Weise mit längs verlaufenden Kühlrippen innerhalb des gehäusebodenseitig verlaufenden zweiten Luftführungsabschnitts über einen wesentlichen Teil der gesamten Gehäusebreite aus, so dass möglichst viel Abwärme an die Kühlluft abgegeben werden kann. Von Vorteil ist zudem, dass auch der dritte Luftführungsabschnitt einer Seitenwand des Gehäuses angrenzt, so dass auch in diesem Bereich Wärme über das Gehäuse nach außen abgeführt werden kann.

Nachfolgend wird die Erfindung anhand der Zeichnung näher erläutert. Dabei zeigt
- Fig. 1: ein Ausführungsbeispiel eines erfindungsgemä- ßen Hochspannungsprüfgeräts in perspektivi- scher Ansicht und
- Fig. 2: einen schematischen Längsschnitt in einer vertikal verlaufenden Ebene durch das Hoch- spannungsprüfgerät aus Fig. 1.

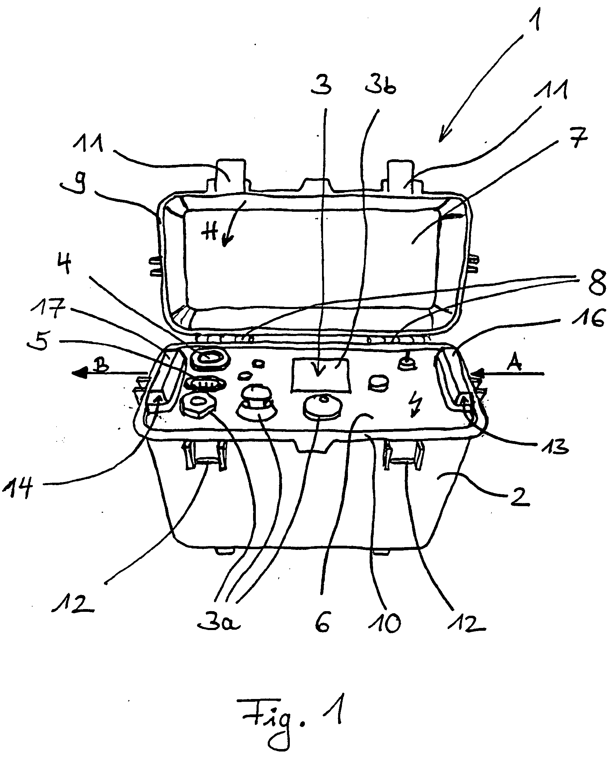

Das in Fig. 1 gezeigte mobile Hochspannungsprüfgerät 1 weist ein Gehäuse 2 auf, in welchem die - in Fig. 1 nicht dargestellte - Elektronik 24 des Hochspannungsprüfgeräts 1 unterhalb der den Bedienbereich 3 und die Anschlüsse 4, 5 aufweisenden Deckplatte 6 dauerhaft aufgenommen ist. Der in Fig. 1 hinten gelegene Anschluss 4 dient als Hochspannungsausgang für das zu prüfende Kabel, während der weiter vorne gelegene Anschluss 5 als Eingang für eine - nicht dargestellte - externe Stromversorgung dient. Auf dem Bedienbereich sind mehrere Bedienelemente 3a sowie ein Display 3b zur Bedienung des Hochspannungsprüfgeräts 1 angeordnet.

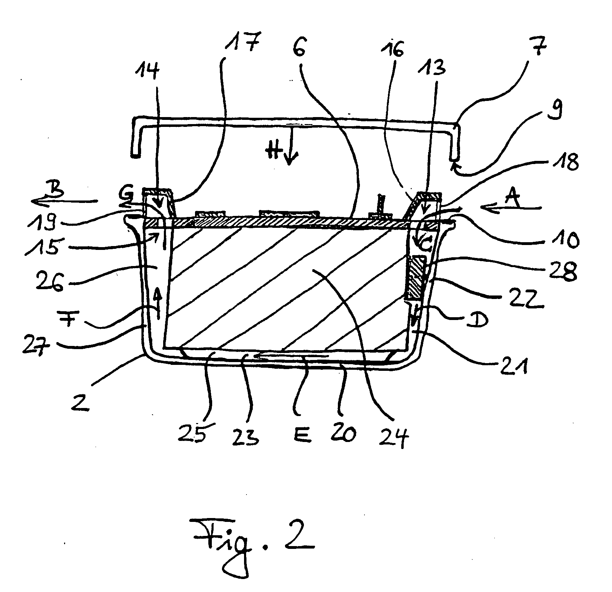

Das Gehäuse 2 umfasst ferner einen Deckelteil in Form eines Gehäusedeckels 7, welcher mittels zweier Scharniere 8 im Bereich der Gehäuseoberseite schwenkbar am übrigen Gehäuse 2 angeordnet ist. Deckelteil 7 und das übrige Gehäuse 2 verfügen über je eine umlaufende Dichtfläche 9, 10, die bei geschlossenem Deckelteil 7 dichtend zusammenwirken, so dass ein Eindringen von Staub oder Schmutz in den vom Deckelteil 7 abgedeckten Bereich des Hochspannungsprüfgeräts 1 ausgeschlossen ist. Am Deckelteil 7 und am übrigen Gehäuse 2 sind Verschlusselemente 11, 12 angeordnet, mit denen das Gehäuse 2 des Hochspannungsprüfgeräts 1 verschließbar ist, nachdem der Deckelteil 7 aus seiner in Fig. 1 dargestellten Öffnungsstellung gemäß Pfeil H (vgl. hierzu auch Fig. 2) in seine Schließstellung verschwenkt wurde. In dieser nicht dargestellten Schließstellung ist das Gehäuse 2 vollständig verschlossen und es sind sowohl sämtliche Anschlüsse 4, 5 und der Bedienbereich 3 als auch die Luftzuführung 13 und die Luftabführung 14 vom Deckelteil 7 verdeckt, während diese in der in Fig. 1 dargestellten Öffnungsstellung freigegeben sind.

Luftzuführung 13 und Luftabführung 14 sind jeweils als Durchbrechung 15 in - bezogen auf die Mitte der Deckplatte 6 - einander gegenüberliegenden Randbereichen der oberen Deckplatte 6 ausgebildet, wobei ferner im Bereich der Luftzu- und Luftabführung 13, 14 je ein Umlenkmittel 15 auf die Durchbrechung aufgesetzt ist, mit welchem auf Seiten der Luftzuführung 13 die gemäß Pfeil A im wesentlichen horizontal von der Seite anströmende Zuluft entsprechend Pfeil C (vgl. Fig. 2) in das Gehäuse 2 hinein umgelenkt wird und auf Seiten der Luftabführung 14 der Abluftstrom gemäß Pfeil G aus dem Gehäuse 2 heraus derart umgelenkt wird, dass die Abluft zur gegenüberliegenden Seite gemäß Pfeil B im wesentlichen horizontal wieder an die Umgebung abgegeben werden kann. Dabei bilden die Umlenkmittel 16, 17 jeweils gleichzeitig eine obere Abdeckung für die Luftzuführung 13 und die Luftabführung 14, so dass kein vertikal von oben kommendes Spritz- oder Regenwasser in das Gehäuse 2 eindringen kann. Auf Seiten des jeweiligen Lufteintritts bzw. Luftaustritts sind die Umlenkmittel 16, 17 nicht vollständig geöffnet, sondern zum Zwecke des Schutzes gegen eindringenden Staub bzw. Wasser mit Luftschlitzen 18, 19 ausgestattet.

In der schematischen Schnittdarstellung aus Fig. 2 ist der Kühlluftstrom durch das Hochspannungsprüfgerät 1 veranschaulicht. Nach ihrem umgelenkten Eintritt in das Gehäuse 2 durchströmt die Kühlluft gemäß Pfeil D einen ersten, von der Luftzuführung 13 zum Gehäuseboden 20 führenden Luftführungsabschnitt 21, welcher einerseits von einer Seitenwand 22 des Gehäuses 2 und andererseits von der Elektronik 24 begrenzt ist. Im ersten Luftführungsabschnitt 21 ist ein als Radiallüfter ausgebildeter Lüfter 28 platzsparend angeordnet.

Am Gehäuseboden 20 angekommen, wird die Kühlluft in einen zweiten Luftführungsabschnitt 23 abgelenkt, in welchem die Kühlluft das Gehäuse 2 gemäß Pfeil E in Längsrichtung durchquert. Oberhalb dieses zweiten Luftführungsabschnitts befindet sich die - nur schematisch dargestellte - Elektronik 24 des Hochspannungsprüfgeräts 1, welche über einen Tragkörper der Elektronik 24 mit einem Kühlkörper verbunden ist, der in Form von in Längsrichtung verlaufenden Lamellen 25, zwischen denen die Kühlluft strömen kann, den zweiten Luftführungsabschnitt 23 begrenzt. Dabei sind die Lamellen 25 gleichzeitig in Kontakt mit der Innenseite des Gehäusebodens 20, so dass die Abwärme - neben einem Wärmeabtransport durch die Kühlluft - auch über die Gehäusewand an die Umgebung abgegeben werden kann.

Dem zweiten Luftführungsabschnitt 23 schließt sich ein dritter Luftführungsabschnitt 26 an, welcher wieder durch eine Seitenwand 27 des Gehäuses 2 begrenzt ist und in welchem die erhitzte Kühlluft gemäß Pfeil F vom Gehäuseboden 20 zur Luftabführung 14 an der gehäuseoberseitig angeordneten Deckplatte 6 geführt wird, wo sie schließlich - nach Umlenkung durch das Umlenkmittel 17 gemäß Pfeil G - das Gehäuse wieder horizontal gemäß Pfeil B als Abluft verlassen kann.

## Patentansprüche

1. Mobiles Hochspannungsprüfgerät (1) umfassend
- eine Elektronik (24) mit Mitteln zur Bereitstellung einer im kV-Bereich liegenden Prüfspannung,
- einen mit der Elektronik (24) zusammenwirkenden Bedienbereich (3),
- wenigstens einen Anschluss (4, 5) für das zu prüfende Bauteil oder Kabel und für eine externe Spannungsversorgung,
- ein Gehäuse (2) zur dauerhaften Aufnahme der Elektronik (24),
- sowie ein innerhalb des Gehäuses (2) angeordnetes Kühlsystem zur Kühlung der Elektronik (24), welches eine Luftkühlung mit einer Luftzuführung (13) und einer Luftabführung (14) umfasst,
**dadurch gekennzeichnet,**
**dass** das Gehäuse (2) einen zwischen einer öffnungs- und einer Schließstellung bewegbaren Deckelteil (7) aufweist, durch welchen in seiner Schließstellung sämtliche Anschlüsse (4, 5), der Bedienbereich (3) sowie die Luftzu- (13) und Luftabführung (14) verdeckt sind, während in seiner Öffnungsstellung sämtliche Anschlüsse (4, 5), der Bedienbereich (3) sowie die Luftzu- (13) und Luftabführung (14) freigegeben sind,
**dass** das Deckelteil (7) in Form eines an der Oberseite des übrigen Gehäuses (2) schwenkbar befestigten Gehäusedeckels ausgebildet ist, welcher in Schließstellung das Gehäuse (2) vollständig verschließt und
**dass** Luftzuführung (13) und Luftabführung (14) auf einander gegenüberliegenden Seiten in voneinander entfernten und bezogen auf die Mitte der Deckplatte (6) einander gegenüberliegenden seitlichen Randbereichen einer die Oberseite des in Schließstellung vom Gehäusedeckel (7) abgedeckten Teils des Hochspannungsprüfgeräts (1) bildenden Deckplatte (6) angeordnet sind, so dass bei Betrieb des Hochspannungsprüfgeräts mit geöffnetem Deckelteil (7) die Zuluft für die Luftkühlung im Bereich der Oberseite des Hochspannungsprüfgeräts auf einer Seite der Deckplatte (6) angesaugt und die erwärmte Abluft auf der anderen Seite der Deckplatte (6) wieder abgegeben werden kann.

2. Hochspannungsprüfgerät (1) nach Anspruch 1,
**dadurch gekennzeichnet,**
**dass** an der Luftzuführung (13) und Luftabführung (14) Umlenkmittel (16, 17) für die Zuluft und die Abluft vorgesehen sind, die beim Betrieb des Hochspannungsprüfgeräts (1) ein seitliches Ansaugen der Zuluft (Pfeil A) und eine seitliche Abgabe der Abluft zur gegenüberliegenden Seite (Pfeil B) bewirken.

3. Hochspannungsprüfgerät (1) nach einem dervorangehenden Ansprüche,
**dadurch gekennzeichnet,**
**dass** Luftzuführung (13) und Luftabführung (14) zur Seite hin offen und nach oben hin dauerhaft abgedeckt sind.

4. Hochspannungsprüfgerät (1) nach Anspruch 3,
**dadurch gekennzeichnet,**
**dass** die Kühl- und Abluft im Bereich der Luftzu-(13) und Luftabführung (14) im Wesentlichen horizontal angesaugt und abgegeben oder von schräg unten angesaugt und nach schräg unten abgegeben werden.

5. Hochspannungsprüfgerät (1) nach Anspruch 1,
**dadurch gekennzeichnet,**
**dass** die Luftkühlung das Primärkühlsystem des Hochspannungsprüfgeräts (1) darstellt.

6. Hochspannungsprüfgerät (1) nach Anspruch 5,
**dadurch gekennzeichnet,**
**dass** das Kühlsystem einen ersten Luftführungsabschnitt (21) aufweist, in welchem ein Lüfter (28) zur Ansaugung der Kühlluft angeordnet ist und in welchem die durch die Luftzuführung (13) im Bereich der Gehäuseoberseite angesaugte Kühlluft an der Innenseite einer Gehäuseseitenwand (22) zum Gehäuseboden (20) geleitet wird,
wobei sich dem ersten Luftführungsabschnitt (21) ein zweiter Luftführungsabschnitt (23) anschließt, der das Gehäuse (2) gehäusebodenseitig in Längsrichtung (Pfeil E) durchquert, einem Kühlkörper (25) der Elektronik (24) angrenzt und zu einem dritten Luftführungsabschnitt (26) an der gegenüberliegenden Gehäuseseitenwand (27) führt, in welchem die Kühlluft wieder in Richtung zur Gehäuseoberseite zur Luftabführung (14) geführt wird.

## Claims

1. A mobile high-voltage test unit (1) comprising
- electronics (24) with means for the provision of a test voltage in the kV range,
- an operating region (3) interacting with the electronics (24), at least one connection (4, 5) for the component or cable to be tested, and for an external voltage supply,
- a housing (2) for the permanent accommodation of the electronics (24),
- also a cooling system arranged within the housing (2) for purposes of cooling the electronics (24), which comprises an air cooling system with a means of air supply (13) and air extraction (14),
**characterised in that**,
the housing (2) has a cover (7) that can be moved between an open position and a closed position, by means of which in its closed position all connections (4, 5), the operating area (3), and also the means of air supply (13) and air extraction (14) are covered, while in its open position all connections (4, 5), the operating area (3), and also the means of air supply (13) and air extraction (14) are exposed, ,
and **in that** the cover (7) is designed in the form of a housing cover attached to the upper side of the other part of the housing (2) such that it can pivot, which in the closed position fully closes off the housing (2), and
**in that** the means of air supply (13) and air extraction (14) are arranged on opposite sides in lateral edge regions of a cover plate (6) that are remote from one another and with reference to the centre of the cover plate (6) are located opposite one another, the cover plate (6) forming the upper face of the part of the high-voltage test unit (1) that is covered in the closed setting of the housing cover (7), so that in operation of the high voltage test unit with an opened cover (7), the supply air for the air cooling system in the region of the upper face of the high-voltage test unit can be sucked in on one side of the cover plate (6), and the heated exhaust air can be re-emitted on the other side of the cover plate (6).

2. The high-voltage test unit (1) in accordance with Claim 1,
**characterised in that**
means of turning (16, 17) are provided on the means of air supply (13) and air extraction (14) for the incoming and outgoing air, which during operation of the high-voltage test unit (1) effect a lateral suction of the incoming air (arrow A) and a lateral extraction of the outgoing air to the opposite side (arrow B).

3. The high-voltage test unit (1) in accordance with one of the preceding claims,
**characterised in that**
the means of air supply (13) and air extraction (14) are permanently open to the side, and are permanently covered in the upward direction.

4. The high-voltage test unit (1) in accordance with Claim 3,
**characterised in that**
the cooling air and outgoing air in the region of the means of air supply (13) and air extraction (14) are sucked in and extracted horizontally, or are sucked in obliquely from underneath, and are extracted obliquely in the downward direction.

5. The high-voltage test unit (1) in accordance with Claim 1,
**characterised in that**
the air cooling system represents the primary cooling system of the high-voltage test unit (1).

6. The high-voltage test unit (1) in accordance with Claim 5,
**characterised in that**
the cooling system has a first air guidance section (21), in which a fan (28), is arranged for purposes of sucking in the cooling air, and in which the cooling air sucked in through the means of air supply (13) in the region of the housing upper face is directed on the inner side of a housing sidewall (22) towards the housing floor (20), wherein
the first air guidance section (21) connects to a second air guidance section (23), which crosses the housing (2) on the housing floor face in the longitudinal direction (arrow E), is adjacent to a cooling body (25) of the electronics (24), and leads to a third air guidance section (26) on the opposite housing sidewall (27), in which the cooling air is again guided in the direction towards the housing upper face for purposes of air extraction (14).

## Revendications

1. Appareil mobile de test de haute tension (1) comprenant
- une électronique (24) avec des moyens pour la fourniture d'une tension d'essai de l'ordre du kV,
- une zone de commande (3) coopérant avec l'électronique (24),
- au moins un branchement (4, 5) pour le composant ou câble à tester et pour une alimentation externe en tension,
- un boîtier (2) pour le logement permanent de l'électronique (24),
- et un système de refroidissement disposé à l'intérieur du boîtier (2) pour le refroidissement de l'électronique (24), qui comprend un refroidissement par air avec une arrivée d'air (13) et une évacuation d'air (14),
**caractérisé en ce que**
le boîtier (2) présente une partie de couvercle (7) pouvant se déplacer entre une position d'ouverture et une position de fermeture, par laquelle, dans sa position de fermeture, tous les branchements (4, 5), la zone de commande (3) ainsi que l'arrivée d'air (13) et l'évacuation d'air (14) sont masqués, alors que, dans sa position d'ouverture, tous les branchements (4, 5), la zone de commande (3) ainsi que l'arrivée d'air (13) et l'évacuation d'air (14) sont autorisés, **en ce que** la partie de couvercle (7), est conçue sous la forme d'un couvercle de boîtier fixé de façon pivotante sur le côté supérieur du boîtier (2) restant, lequel couvercle ferme complètement le boîtier (2) dans la position de fermeture et
**en ce que** l'arrivée d'air (13) et l'évacuation d'air (14) sont disposées sur des côtés se faisant face, dans des zones de bord latérales éloignées les unes des autres et situées en vis-à-vis les unes des autres par rapport au milieu de la plaque de recouvrement (6), d'une plaque de recouvrement (6) formant le côté supérieur de la partie, masquée par le couvercle de boîtier (7) dans la position de fermeture, de l'appareil de test de haute tension (1), de sorte que lors du fonctionnement de l'appareil de test de haute tension avec la partie de couvercle (7) ouverte, l'air frais pour le refroidissement d'air dans la zone du côté supérieur de l'appareil de test de haute tension est aspiré sur un côté de la plaque de recouvrement (6) et que l'air d'évacuation échauffé puisse de nouveau être dégagé sur l'autre côté de la plaque de recouvrement (6).

2. Appareil de test de haute tension (1) selon la revendication 1,
**caractérisé en ce que**
des moyens (16, 17) de déviation sont prévus sur l'arrivée d'air (13) et l'évacuation d'air (14) pour l'air frais et l'air sortant, lesquels moyens entraînent une aspiration latérale de l'air entrant (flèche A) et une distribution latérale de l'air sortant vers le côté opposé (flèche B) lorsque l'appareil de test de haute tension (1) est en service.

3. Appareil de test de haute tension (1) selon l'une quelconque des revendications précédentes,
**caractérisé en ce que**
l'entrée d'air (13) et l'évacuation d'air (14) sont couvertes vers le côté et sont masquées de façon permanente vers le haut.

4. Appareil de test de haute tension (1) selon la revendication 3,
**caractérisé en ce que**
l'air entrant et l'air sortant sont aspirés et distribués sensiblement horizontalement dans la zone de l'arrivée d'air (13) et de l'évacuation d'air (14) ou sont aspirés en biais par le bas et sont distribués en biais vers le haut.

5. Appareil de test de haute tension (1) selon la revendication 1,
**caractérisé en ce que**
le refroidissement par air représente le système de refroidissement primaire de l'appareil de test de haute tension (1).

6. Appareil de test de haute tension (1) selon la revendication 5,
**caractérisé en ce que**
le système de refroidissement présente un premier tronçon de guidage d'air (21), dans lequel est disposé un aérateur (28) pour l'aspiration de l'air de refroidissement et dans lequel l'air de refroidissement aspiré par l'arrivée d'air (13) dans la zone du côté supérieur du boîtier est conduit sur le côté intérieur d'une paroi latérale de boîtier (22) vers le fond du boîtier (20),
sur lequel un second tronçon de guidage d'air (23) se raccorde au premier tronçon de guidage d'air (21), traverse le boîtier (2) côté fond du boîtier dans le sens longitudinal (flèche E), est contigu à un corps de refroidissement (25) de l'électronique (24) et aboutit à un troisième tronçon de guidage d'air (26) sur la paroi latérale de boîtier (27) opposée, tronçon dans lequel l'air de refroidissement est guidé à nouveau en direction du côté supérieur du boîtier pour l'évacuation d'air (14).
